# FASCICULE DE BREVET EUROPEEN

(11) **EP 3 428 666 B1**
(45) Date de publication et mention de la délivrance du brevet: **03.08.2022**
(21) Numéro de dépôt: 18176393.9
(22) Date de dépôt: 07.06.2018
(51) Int. Cl.: G01R 31/327, H01H 1/00, H01H 9/56, H03K 17/28, H01H 11/00, H01H 71/04

(54) **DISPOSITIF DE COMMUTATION ÉLECTRIQUE ET PROCÉDÉ DE DÉTECTION D'USURE ASSOCIÉ**
ELEKTRISCHE SCHALTVORRICHTUNG UND DAZUGEHÖRIGES VERFAHREN ZUR VERSCHLEISSERKENNUNG
ELECTRICAL SWITCHING DEVICE AND ASSOCIATED METHOD FOR DETECTING WEAR

(30) Priorité: 13.07.2017 FR 1756682
(43) Date de publication de la demande: 16.01.2019
(73) Titulaire: Schneider Electric Industries SAS, 92500 Rueil-Malmaison (FR)
(72) Inventeur: LAPIERE, Christophe, 38050 GRENOBLE (FR); URANKAR, Lionel, 38050 GRENOBLE (FR)
(74) Mandataire: Lavoix

(56) Documents cités:
- EP-A1- 0 333 139
- EP-A1- 1 006 537
- EP-A1- 1 793 235
- EP-A1- 2 200 055
- EP-A1- 2 975 622
- WO-A1-02/23207
- DE-A1-102010 043 744
- DE-C1- 19 544 926
- DE-U1-202017 002 030
- FR-A1- 2 792 766
- FR-A1- 2 919 109
- JP-A- S57 151 829
- US-A- 2 864 054
- US-A- 4 159 446
- US-A- 4 620 156
- US-A1- 2004 189 319
- US-A1- 2005 237 064
- US-A1- 2014 090 965
- US-A1- 2017 047 186
- US-B1- 6 215 408
- US-B2- 8 688 391

## Description

La présente invention concerne un dispositif de commutation électrique et un procédé de détection d'usure associé.

Des dispositifs de commutation sont utilisés dans un grand nombre d'applications pour commander le passage d'un courant électrique. Par exemple, des dispositifs de commutation, tels que des contacteurs, sont utilisés pour alimenter à la demande des installations électriques ou des portions d'un réseau de distribution d'électricité. De tels dispositifs de commutation sont en général commandés à distance, via un module de communication filaire ou radiofréquence. D'autres types de dispositifs de commutation, tels que des disjoncteurs, sont configurés pour détecter un incident électrique, par exemple un court-circuit, une surtension ou encore une sous-tension, et pour interrompre automatiquement le passage du courant, sans intervention extérieure.

Les dispositifs de commutation précités sont donc des éléments importants du bon fonctionnement d'installations électriques ou de réseaux électriques, puisque leur défaillance peut entraîner des risques électriques importants si le passage du courant n'est pas correctement interrompu, ou au contraire empêcher une alimentation électrique correcte des installations à alimenter.

Or, les dispositifs de commutation sont soumis, au cours de leur durée de vie, à de nombreux cycles de commutation, qui entraînent nécessairement une usure, notamment des parties mobiles du dispositif ou des pastilles de contact. Une telle usure est susceptible de déboucher sur un mauvais fonctionnement du dispositif de commutation, et en particulier sur une commutation inadéquate voire impossible si un échauffement entraîne la soudure d'un contact mobile sur une plage de connexion.

Des dispositifs de commutation équipés de moyens d'évaluation de la durée de vie restante des parties mobile du dispositif existent, et permettent d'effectuer une maintenance préventive voire un remplacement des pièces usées avant que cette usure n'entraîne une défaillance du dispositif. Cependant, les moyens d'évaluation utilisés ne sont pas optimisés. En particulier, les moyens d'évaluation ne sont adaptés qu'à certains types de dispositifs de commutation particuliers ou à certaines causes d'usure.

Par exemple, le document WO 0063932 A1 décrit un dispositif de commutation dans lequel un contact électrique est diagnostiqué par la mesure d'une tension électrique entre deux contacts électriques. Cependant, si une telle mesure est aisée dans des dispositifs à basse tension, elle est peu adaptée à des réseaux à tension plus élevée, par exemple de 380 Volt ou plus.

Les documents EP 0333 139 A1, DE 10 2010 043744 A1, DE 20 2017002030 U1, US 2017/047186 A1, US 6 215 408 B1, US 4 159 446 A, US 8 688 391 B2 et EP 1 006 537 A1 décrivent chacun un dispositif de commutation électrique comportant un accéléromètre. Le document US 2014/090965 A1 décrit un dispositif de commutation électrique comportant un transducteur mesurant une durée de commutation, dont est déduite une accélération du dispositif de commutation.

L'invention a pour but de proposer un dispositif de commutation électrique permettant une meilleure détection de l'usure des parties mobiles du dispositif de commutation.

A cet effet, l'invention a pour objet un dispositif de commutation électrique comme décrit dans la revendication 1. Il comprend au moins une plage de connexion d'entrée, au moins une plage de connexion de sortie, et au moins un organe de connexion propre à commuter entre une position fermée autorisant le passage du courant électrique entre les plages de connexion d'entrée et de sortie et une position ouverte empêchant le passage du courant électrique entre les plages de connexion d'entrée et de sortie, le dispositif de commutation électrique comportant un accéléromètre propre à mesurer au moins une composante d'une accélération du dispositif de commutation électrique lors d'une commutation de l'organe de connexion entre la position fermée et la position ouverte et un contrôleur configuré pour estimer, à partir d'au moins un signal de mesure d'accélération délivré par l'accéléromètre, une durée de commutation de l'organe de connexion entre la position fermée et la position ouverte, et pour déterminer une usure du dispositif de commutation électrique à partir, au moins, de la durée de commutation estimée.

Suivant d'autres aspects avantageux mais non obligatoires de l'invention, le dispositif de commutation comprend une ou plusieurs des caractéristiques suivantes, prise(s) isolément ou selon toutes les combinaisons techniquement possibles :
- le contrôleur est configuré pour déterminer une usure du dispositif de commutation lorsque la durée de commutation est supérieure ou égale à un seuil prédéterminé.
- le contrôleur est configuré pour vérifier si l'usure déterminée est supérieure à un seuil d'usure prédéterminé et, dans l'affirmative, pour générer un signal de détection à destination d'un usager du dispositif de commutation électrique.
- le dispositif de commutation électrique comporte un boîtier propre à isoler électriquement l'organe de connexion de l'extérieur du boîtier, l'organe de connexion étant mobile par rapport au boîtier entre sa position ouverte et sa position fermée, et dans lequel l'accéléromètre est solidaire du boîtier.
- le dispositif de commutation électrique comporte un boîtier propre à isoler électriquement l'organe de connexion de l'extérieur du boîtier, l'organe de connexion étant mobile par rapport au boîtier entre sa position ouverte et sa position fermée, et dans lequel l'accéléromètre est solidaire de l'organe de connexion et par conséquent mobile par rapport au boîtier.
- le contrôleur est configuré pour détecter, lorsque l'organe de connexion commute entre la position fermée et la position ouverte, un instant de début et un instant de fin de course d'une course de l'organe de connexion, et pour estimer la durée de commutation à partir des instants de début et de fin de course détectés.
- le contrôleur est configuré pour comparer une amplitude du signal de mesure d'accélération à un premier seuil et pour détecter l'instant de début de course lorsque l'amplitude dépasse le premier seuil.
- le contrôleur est configuré pour comparer une amplitude d'un signal de mesure de l'accélération à un deuxième seuil et pour détecter l'instant de fin de course lorsque, après qu'un instant de début de course a été détecté, l'amplitude devient supérieure ou égale au deuxième seuil.
- l'organe de connexion, selon la présente invention d'une façon obligatoire, comprend un élément de connexion et un actionneur, l'élément de connexion étant mobile par rapport aux plages de connexion entre une première position et une deuxième position et étant configuré pour connecter électriquement les deux plages de connexion lorsque l'élément de connexion est dans la première position et pour déconnecter électriquement les deux plages de connexion lorsque l'élément de connexion est dans la deuxième position, l'actionneur comprenant au moins une partie mobile par rapport aux plages de connexion entre une troisième position et une quatrième position, la partie mobile étant dans la troisième position et l'élément de connexion étant dans la première position lorsque l'organe de connexion est dans la position fermée, la partie mobile étant dans la quatrième position et l'élément de connexion étant dans la deuxième position lorsque l'organe de connexion est dans la position ouverte, la partie mobile étant configurée pour être distante de l'élément de connexion lorsque la partie mobile est dans la troisième position et étant configurée pour, lors de son déplacement depuis la troisième position jusqu'à la quatrième position, venir en appui contre l'élément de connexion pour déplacer l'élément de connexion depuis la première position jusqu'à la deuxième position, le contrôleur étant, en outre, configuré pour détecter, à partir, au moins, du signal de mesure d'accélération, un instant de fin d'appui d'un appui de la partie mobile contre l'élément de connexion, l'usure étant déterminée, en outre, à partir de l'instant de fin d'appui détecté.
- le signal de mesure d'accélération comprend un ensemble de composantes fréquentielles présentant chacune une intensité, le contrôleur étant configuré pour détecter l'instant de fin d'appui lorsque, sur une gamme continue de fréquences présentant une largeur fréquentielle prédéterminée, l'intensité de chaque composante fréquentielle est supérieure ou égale à un troisième seuil prédéterminé.
- le dispositif de commutation est un contacteur.

L'invention a également pour objet un procédé de détection d'usure pour un dispositif de commutation électrique comme décrit dans la revendication 11, ledit dispositif comprenant un accéléromètre, au moins une plage de connexion d'entrée, une plage de connexion de sortie et un organe de connexion, propre à commuter entre une position fermée autorisant le passage du courant électrique entre les plages de connexion d'entrée et de sortie et une position fermée empêchant le passage du courant électrique, le procédé comprenant des étapes de :
- commutation de l'organe de connexion entre la position fermée et la position ouverte,
- génération, par l'accéléromètre, d'un signal de mesure d'accélération correspondant au moins à une composante d'une accélération du dispositif de commutation lors de la commutation,
- estimation, à partir du signal de mesure d'accélération, d'une durée de commutation de l'organe de connexion entre la position fermée et la position ouverte, et
- détermination d'une usure du dispositif de commutation à partir, au moins, de la durée de commutation estimée.

Selon un aspect avantageux mais non obligatoire de l'invention, le procédé comprend, en outre, une étape de calibration consistant à générer un signal de mesure d'accélération pendant au moins une commutation et à identifier, dans le signal de mesure d'accélération fourni par l'accéléromètre, au moins une signature d'un instant de début ou de fin de course de l'organe de connexion, l'étape d'estimation comprenant la détection d'un instant de début ou de fin de course de l'organe de connexion par comparaison du signal de mesure d'accélération généré pendant l'étape de génération à la signature identifiée.

Les caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un mode de réalisation préféré d'un dispositif de commutation électrique selon l'invention, comprenant un organe de connexion et deux plages de connexion, en position fermée, l'organe de connexion étant connecté électriquement aux deux plages de connexion ;
- la figure 2 est une représentation schématique du dispositif de commutation de la figure 1, en position ouverte, l'organe de connexion étant déconnecté des deux plages de connexion ;
- la figure 3 est un ordinogramme des étapes d'un exemple de procédé de détection d'usure pour le dispositif de commutation de la figure 1 ;
- la figure 4 est un graphe représentant la variation temporelle de la position de l'organe de connexion et de trois composantes de l'accélération du dispositif de commutation, au cours d'une commutation ; et
- la figure 5 est un graphe représentant l'amplitude d'un signal de mesure d'accélération du dispositif de commutation en fonction de la fréquence, au cours d'une commutation.

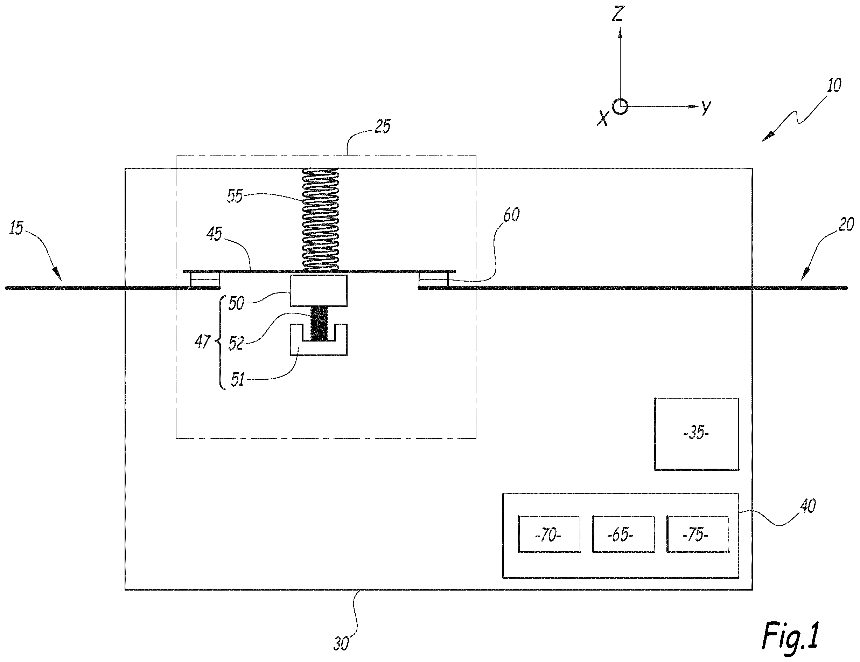

Un premier exemple de dispositif de commutation 10 est représenté sur la figure 1.

Le dispositif de commutation 10 est configuré pour recevoir un courant électrique C d'un premier conducteur électrique et pour transmettre le courant C à un deuxième conducteur électrique. Le dispositif de commutation 10 est, en outre, configuré pour interrompre le passage du courant électrique C entre le premier et le deuxième conducteur électrique.

Le dispositif de commutation 10 est, par exemple, un contacteur. Un contacteur est un dispositif de commutation configuré pour permettre ou interrompre le passage du courant électrique C en réponse à un signal de commande correspondant. Le signal de commande correspondant est, par exemple, un signal électrique ou pneumatique émis par un dispositif de commande distant du dispositif de commutation.

Selon une variante, le dispositif de commutation 10 est un disjoncteur configuré pour mesurer une valeur une grandeur électrique du courant C et pour permettre ou interrompre le passage du courant C en fonction de la valeur mesurée.

Le dispositif de commutation 10 comporte au moins une plage de connexion d'entrée 15, au moins une plage de connexion de sortie 20, au moins un organe de connexion 25, un boîtier 30, un accéléromètre 35 et un contrôleur 40.

Selon l'exemple de la figure 1, le dispositif de commutation 10 comporte une unique plage de connexion d'entrée 15, une unique plage de connexion de sortie 20 et un unique organe de connexion 25. Il est à noter que le nombre de plages de connexion d'entrée 15, de plages de connexion de sortie 20 et d'organes de commutation 25 est susceptible de varier. Par exemple, dans un mode de réalisation, le dispositif de commutation 10 est un dispositif de commutation triphasé comprenant trois plages de connexion d'entrée 15, trois plages de connexion de sortie 20 et trois organes de commutation 25. Selon une variante, un unique organe de connexion 25 est commun à toutes les plages de connexion d'entrée et de sortie 15, 20.

Trois directions X, Y et Z d'un repère tridimensionnel direct lié au dispositif de commutation 10 sont représentées sur la figure 1. Les trois directions X, Y ou Z sont perpendiculaires les unes aux autres.

La plage de connexion d'entrée 15 est configurée pour être connectée au premier conducteur et pour recevoir le courant électrique C du premier conducteur électrique.

La plage de connexion de sortie 20 est configurée pour être connectée au deuxième conducteur et pour transmettre le courant électrique C au deuxième conducteur électrique.

Selon l'exemple de la figure 1, chaque plage de connexion d'entrée ou de sortie 15, 20 est une pièce métallique configurée pour, à une extrémité, être connectée au conducteur électrique correspondant et, à une autre extrémité, être mise en contact de l'organe de connexion 25. En variante, chaque plage de connexion 15, 20 comporte un ensemble de pièces électriquement conductrices connectées les unes aux autres.

L'organe de connexion 25 est mobile par rapport au boîtier 30 et aux plages de connexion d'entrée et de sortie 15, 20 entre une position fermée et une position ouverte.

Sur la figure 1, l'organe de connexion 25 est représenté dans sa position fermée. Lorsque l'organe de connexion 25 est dans la position fermée, l'organe de connexion 25 autorise le passage du courant C entre les plages de connexion d'entrée et de sortie 15, 20.

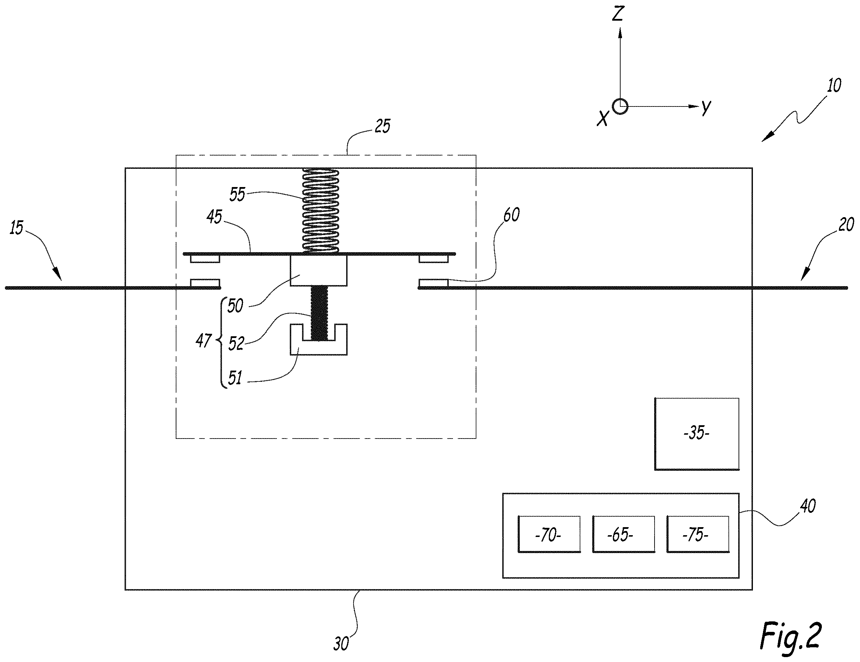

Sur la figure 2, l'organe de connexion 25 est représenté dans sa position ouverte. Lorsque l'organe de connexion 25 est dans la position ouverte, l'organe de connexion 25 empêche le passage du courant C entre les plages de connexion d'entrée et de sortie 15, 20.

L'organe de connexion 25 est configuré pour commuter entre ses positions ouverte et fermée.

Par exemple, lorsque le dispositif de commutation 10 est un contacteur, l'organe de connexion 25 est configuré pour commuter entre les positions ouverte et fermée suite à la réception des signaux de commande correspondants. Lorsque le dispositif de commutation 10 est un disjoncteur, l'organe de connexion 25 est configuré pour commuter entre les positions ouverte et fermée en fonction des valeurs de la grandeur du courant C mesurées.

Selon l'exemple de la figure 1, l'organe de connexion 25 comporte un élément de connexion 45, un actionneur 47 et un ressort de pôle 55.

L'élément de connexion 45 est mobile par rapport aux plages de connexion 15, 20 entre une première position, visible sur la figure 1, et une deuxième position visible sur la figure 2. Par exemple, l'élément de connexion 45 est mobile en translation selon la direction Z entre la première position et la deuxième position.

Lorsque l'organe de connexion 25 est dans la position fermée, l'élément de connexion 45 est dans sa première position et connecte électriquement les deux plages de connexion d'entrée et de sortie 15, 20.

Lorsque l'organe de connexion 25 est dans la position ouverte, l'élément de connexion 45 est dans sa deuxième position et les deux plages de connexion d'entrée et de sortie 15, 20 sont déconnectées électriquement l'une de l'autre. Lorsque l'élément de connexion 45 est dans sa deuxième position, l'élément de connexion 45 est, par exemple, en appui contre un élément de butée correspondant.

L'élément de connexion 45 est réalisé en un matériau électriquement conducteur.

L'élément de connexion 45 porte deux pastilles de contact 60. Les pastilles de contact 60 sont des éléments métalliques prévus pour être plaquées par l'élément de connexion 45 contre les plages de connexion d'entrée et de sortie 15, 20 correspondantes lorsque l'élément de connexion 45 est dans la première position.

Selon l'exemple de la figure 1, des pastilles de contact 60 sont également portées par les plages de connexion d'entrée et de sortie 15, 20.

Chaque pastille de contact 60 présente une épaisseur e, mesurée selon la direction Z.

L'actionneur 47 est configuré pour faire commuter l'organe de connexion 25 entre la position ouverte et la position fermée. En particulier, l'actionneur 47 est configuré pour déplacer l'élément de connexion 45 entre sa première position et sa deuxième position.

L'actionneur 47 comporte une partie mobile 50, une partie fixe 51 et un ressort de rappel 52.

La partie mobile 50 est mobile entre une troisième position, visible sur la figure 1, et une quatrième position visible sur la figure 2.

Lorsque l'organe de connexion 25 est dans la position fermée, l'actionneur 50 est dans la troisième position. Lorsque la partie mobile 50 est dans la troisième position, la partie mobile 50 est distante de l'élément de connexion 45. En particulier, lorsque la partie mobile 50 est dans la troisième position, la partie mobile 50 n'est pas en contact avec l'élément de connexion 45.

Lorsque la partie mobile 50 est dans la troisième position, la partie mobile est, par exemple, en appui contre la partie fixe 51.

Lorsque l'organe de connexion 25 est dans la position ouverte, la partie mobile 50 est dans la quatrième position. Lorsque la partie mobile 50 est dans la quatrième position, la partie mobile 50 est en appui contre l'élément de connexion 45.

La partie mobile 50 est configuré pour se déplacer entre la troisième position et la quatrième position. Par exemple, la partie mobile 50 comporte une bobine configurée pour générer une force tendant à déplacer la partie mobile depuis la troisième position jusqu'à la quatrième position lorsque la bobine est traversée par un courant électrique.

La partie mobile 50 est configurée pour, lors de son déplacement depuis la troisième position jusqu'à la quatrième position, exercer une force via le ressort de pôle 55 sur l'élément de connexion 45 pour déplacer l'élément de connexion 45 depuis la première position jusqu'à la deuxième position.

Le ressort de rappel 52 est propre à déplacer la partie mobile 50 depuis la troisième position jusqu'à la quatrième position.

Le ressort de pôle 55 est propre à appliquer sur l'élément de connexion 45 une force tendant à déplacer l'élément de connexion 45 depuis la deuxième position jusqu'à la première position.

Le boîtier 30 est propre à isoler électriquement l'organe de connexion 25 de l'extérieur du boîtier 30. Le boîtier 30 est, par exemple, réalisé en matière plastique.

L'accéléromètre 35 est propre à mesurer au moins une amplitude d'une composante c d'une accélération du dispositif de commutation 10, et à délivrer en réponse un signal de mesure d'accélération Sm.

Selon le mode de réalisation préféré décrit en détail, l'accéléromètre 35 est configuré pour mesurer les trois composantes c de l'accélération selon les trois directions X, Y et Z, et à générer en réponse trois signaux de mesure Smx, Smy, Smz correspondants.

Selon l'exemple de la figure 1, l'accéléromètre 35 est solidaire du boîtier 30. Il est par exemple directement fixé sur le boîtier 30. En variante il est fixé sur la carte recevant le contrôleur 40.

Selon un autre mode de réalisation, l'accéléromètre 35 est solidaire de l'organe de connexion 25 et par conséquent mobile par rapport au boîtier 30. Par exemple, l'accéléromètre 35 est solidaire de l'élément de connexion 45.

Le contrôleur 40 est configuré pour recevoir de l'accéléromètre 35 chaque signal de mesure d'accélération Smx, Smy, Smz.

Le contrôleur 40 est configuré pour déterminer une usure du dispositif de commutation 10 à partir au moins du signal de mesure d'accélération Sm. Par exemple, le contrôleur 40 est configuré pour estimer, au cours d'une commutation de l'organe de connexion 25 entre la position fermée et la position ouverte, une durée de commutation Dc de l'organe de connexion 25, et pour déterminer l'usure à partir au moins de la durée de commutation Dc.

Il est entendu par « usure » une détérioration d'une partie du dispositif de commutation 10. Par exemple, le contrôleur 40 est configuré pour déterminer une usure de l'organe de commutation 25.

L'usure est, par exemple, une usure des pastilles de contact 60. Une diminution de l'épaisseur e des pastilles de contact 60 en-dessous d'une épaisseur limite est un exemple d'usure de l'organe de commutation 25. Il est à noter que d'autres types d'usure sont susceptibles d'être déterminées.

Le contrôleur 40 est, par exemple, solidaire du boîtier 30.

Le contrôleur 40 comporte un processeur 65, une mémoire 70 et un module de signalisation 75.

Un programme d'ordinateur est mémorisé dans la mémoire 70. Le programme d'ordinateur comporte des instructions logicielles qui, lorsqu'elles sont exécutées sur le processeur 65, entraînent la mise en œuvre d'un procédé de détection d'usure du dispositif de commutation 10.

Le module de signalisation 75 est configuré pour transmettre, à un usager du dispositif de commutation 10, un signal de détection indiquant à l'usager qu'une usure du dispositif de commutation 10 est détectée. Par exemple, le module de signalisation 75 comporte un émetteur lumineux porté visible à travers une ouverture du boîtier 30 et qui est allumée pour indiquer qu'une usure est détectée.

Selon une variante, le module de signalisation 75 est configuré pour transmettre, par exemple par liaison filaire ou par communication radiofréquence, par exemple à courte portée de type RFID, un signal de détection Su à un dispositif distant configuré pour afficher une alerte à destination de l'usager.

Le fonctionnement du dispositif de commutation 10 va maintenant être décrit.

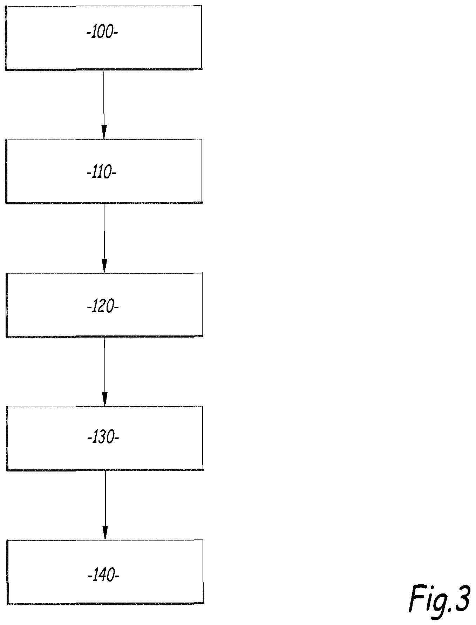

Un ordinogramme des étapes d'un procédé de détection d'usure mis en œuvre par le dispositif de commutation électrique 10 est représenté sur la figure 3.

Le procédé comprend une étape 100 de calibration, une étape 110 de commutation, une étape 120 de génération d'un signal de mesure, une étape 130 d'estimation de la durée de commutation et une étape 140 de détermination d'une usure.

Au cours de l'étape de calibration 100, au moins une commutation de l'organe de connexion 25 est mise en œuvre. Par exemple, au moins dix commutations de l'organe de connexion 25 sont mises en œuvre.

Chaque commutation est, par exemple, un déplacement de l'organe de commutation 25 depuis la position fermée jusqu'à la position ouverte. En variante, chaque commutation est un déplacement de l'organe de commutation 25 depuis la position ouverte jusqu'à la position fermée.

Lors de chaque commutation, la partie mobile 50 se déplace depuis sa troisième position vers sa quatrième position. Lorsque la partie mobile 50 entre en contact avec l'élément de connexion 45, la partie mobile 50 exerce sur l'élément de connexion 45 une force tendant à déplacer l'élément de connexion 45 depuis sa première position jusqu'à sa deuxième position.

Un instant de début de course T1, un instant de fin de course T2 et un instant de fin d'appui T3 sont définis pour chaque commutation.

L'instant de début de course T1 est l'instant auquel la partie mobile 50 commence à se déplacer depuis la troisième position vers la quatrième position. L'instant de fin de course T2 est l'instant où l'élément de connexion 45 arrive dans la deuxième position. Par exemple, l'instant de fin de course T2 est l'instant où l'élément de connexion 45 arrive en butée contre l'élément de butée correspondant.

L'instant de fin d'appui T3 est l'instant où la partie mobile 50 entre en contact avec l'élément de connexion 45 pour déplacer l'élément de connexion 45 vers la deuxième position. Avant l'instant de fin d'appui T3, l'élément de connexion 45 est en appui contre les deux plages de connexion d'entrée et de sortie 15, 20, et immobile par rapport à ces deux plages de connexion 15, 20.

Au cours de chaque commutation, les valeurs des trois composantes c de l'accélération selon les directions X, Y et Z sont mesurées par l'accéléromètre 35.

Un signal de mesure d'accélération Smx, Smy, Smz est généré par l'accéléromètre 35 pour chaque composante c de l'accélération. Chaque signal de mesure Smx, Smy, Smz est un signal analogique ou numérique représentatif de la valeur de la composante d'accélération mesurée.

Chaque signal de mesure d'accélération Sm présente une amplitude dépendant de la valeur de la composante d'accélération c mesurée.

Selon un mode de réalisation, au moins un filtrage est appliqué à chaque signal de mesure d'accélération Sm.

Par exemple, un filtrage passe-bas est appliqué à chaque signal de mesure d'accélération Sm. Le filtrage passe-bas présente une fréquence de coupure supérieure ou égale à 500 Hertz (Hz).

En variante ou en complément, un filtrage passe-haut est appliqué à chaque signal de mesure d'accélération Sm. Le filtrage passe-haut présente une fréquence de coupure supérieure ou égale à 5 Hz.

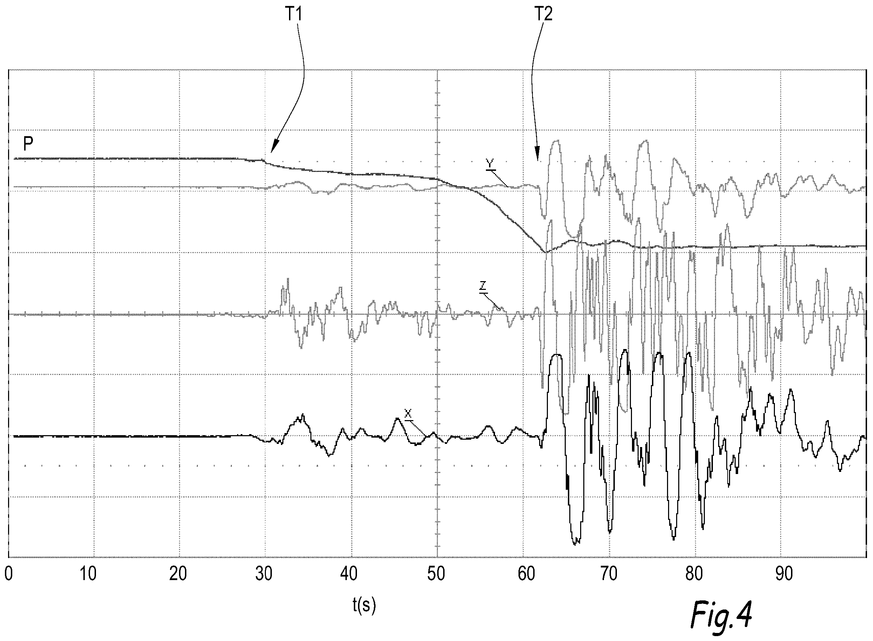

La variation de l'amplitude de chaque signal de mesure d'accélération Smx, Smy, Smz au cours d'une commutation de l'organe de connexion 25, en fonction du temps t, en millisecondes, est représentée sur la figure 4.

La variation de la position de la partie mobile 50 est également représentée sur la figure 4 par une courbe P, montrant les instants de début de course T1 et de fin de course T2.

Des signatures caractéristiques des instants de début de course T1 et de fin de course T2 de l'organe de commutation 25 sont identifiées dans les signaux de mesure d'accélération Smx, Smy, Smz générés pendant les commutations de la phase de calibration.

Il est entendu par « signature » une caractéristique ou un ensemble de caractéristiques d'un ou plusieurs des signaux de mesure d'accélération, associées de façon reproductible à un évènement donné.

Par exemple, sur la figure 4, une signature de l'instant de début de course T1 est l'apparition d'un signal non nul sur la courbe Smx représentant l'amplitude de la composante d'accélération selon la direction X.

En outre, une signature de l'instant de fin de course T2 est l'apparition dans la courbe Smy représentant l'amplitude de la composante d'accélération selon la direction Y, après l'instant de début de course T1, d'un minimum dont la valeur absolue est nettement supérieure aux valeurs absolues des amplitudes de la composante d'accélération selon la direction Y avant l'instant de fin de course T2.

L'étape de calibration 100 est mise en œuvre, par exemple, sur un seul exemplaire de dispositif de commutation électrique 10, les signatures identifiées étant par la suite utilisées dans tous les dispositifs de commutation 10 fabriqués pour identifier les instants de début et de fin de course T1 et T2.

L'étape de calibration 100 est, par exemple, mise en œuvre en usine.

Les étapes de commutation 110, de génération 120, d'estimation 130 et de détermination 140 sont itérées pour chaque dispositif de commutation 10 au cours de son utilisation dans une installation électrique ou dans un réseau de distribution d'électricité.

L'étape de commutation 110 comprend une commutation de l'organe de connexion 25 entre sa position fermée et sa position ouverte. La commutation est, par exemple, commandée à distance par l'usager selon les besoins de l'installation électrique ou du réseau de distribution d'électricité dans lequel le dispositif de commutation 10 est intégré.

Les étapes de génération 120 et d'estimation 130 sont mises en œuvre lors de chaque commutation de l'organe de connexion 25 de chaque dispositif de commutation 10 installé. Selon une variante, les étapes de génération 120 et d'estimation ne sont mises en œuvre que pour certaines commutations, par exemple toutes les dix commutations, ou après une période temporelle minimale depuis la dernière mise en œuvre de ces étapes.

Lors de l'étape de génération 120, trois signaux de mesure Smx, Smy, Smz correspondant aux composantes d'accélération selon les trois directions X, Y et Z sont générés.

Lors de l'étape d'estimation 130, au moins une durée de commutation Dc de l'organe de connexion 25 est estimée. Pour cela, les instants de début de course T1 et de fin de course T2 sont détectés.

La durée de commutation Dc est estimée à partir des instants de début de course T1 et de fin de course T2. En particulier, la durée de commutation Dc est délimitée par l'instant de début de course T1 et par l'instant de fin de course T2.

Les instants de début de course T1 et de fin de course T2 sont détectés par comparaison des signaux de mesure d'accélération Smx, Smy, Smz générés pendant l'étape de commutation avec les signatures correspondantes obtenues lors de la phase de calibration.

Par exemple, l'instant de début de course T1 est identifié par comparaison du signal d'accélération Smx à une signature correspondante. Selon un mode de réalisation particulièrement simple, la signature est le dépassement d'un premier seuil. Le contrôleur 40 compare donc au premier seuil l'amplitude du signal d'accélération Smx. Le premier seuil est, par exemple, égal à un tiers de l'échelle totale de mesure de l'accéléromètre 35.

Lorsque l'amplitude du signal d'accélération Smx dépasse le premier seuil, le contrôleur 40 détecte l'instant de début de course T1.

L'instant de fin de course T2 est identifié par comparaison du signal d'accélération Smy à une signature correspondante. Dans un mode de réalisation particulièrement simple, la signature de l'instant de fin de course T2 est le dépassement, après l'instant de début de course T1, d'un deuxième seuil. Le contrôleur 40 compare donc au deuxième seuil l'amplitude du signal d'accélération Smy. Le deuxième seuil est, par exemple, égal à un tiers de l'échelle totale de mesure de l'accéléromètre 35.

Lorsque l'amplitude du signal d'accélération Smy devient supérieure ou égale au deuxième seuil, après que l'instant de début de course T1 a été détecté, le contrôleur 40 détecte l'instant de fin de course T2. Selon l'exemple de la figure 4, c'est la valeur absolue de l'amplitude du signal d'accélération Smy qui devient supérieure ou égale au deuxième seuil à l'instant de fin de course T2.

Le contrôleur 40 estime la durée de commutation Dc en calculant la différence entre l'instant de début de course T1 et l'instant de fin de course T2.

Au cours de l'étape de détermination 140, l'usure du dispositif de commutation 10 est déterminée à partir de la durée de commutation Dc.

Par exemple, le contrôleur 40 compare la durée de commutation Dc à un troisième seuil prédéterminé et détermine l'usure du dispositif de commutation 10 lorsque la durée de commutation Dc est supérieure ou égale au troisième seuil. Le troisième seuil est, par exemple, compris entre 5 millisecondes (ms) et 40 ms.

En particulier, lorsque la durée de commutation Dc est supérieure ou égale au troisième seuil, le contrôleur 40 détermine que l'usure est supérieure ou égale à un seuil d'usure prédéterminé. Le seuil d'usure correspond, par exemple, à une épaisseur des pastilles de contact 60 en-dessous de laquelle le bon fonctionnement du dispositif de commutation électrique 10 est menacé.

Lorsque le contrôleur 40 détermine que le dispositif de commutation 10 est usé, le contrôleur 40 commande l'émission, par le module de signalisation, d'un signal à destination de l'usager du dispositif de commutation.

Grâce à l'utilisation de l'accéléromètre, une usure du dispositif de commutation 10 est efficacement déterminée. Ainsi, une maintenance préventive et un remplacement des pièces usées à temps est facilité, ce qui limite les risques de dysfonctionnement du dispositif de commutation 10. Le dispositif de commutation 10 est donc plus sécurisé, de même que l'installation électrique ou le réseau de distribution d'électricité dans lequel le dispositif de commutation 10 est installé.

En outre, la détection d'usure par un accéléromètre est compatible avec un grand nombre d'applications, y compris à des applications à tension élevée de 380 Volt ou plus.

La détection des instants de début et de fin de course T1, T2 par comparaison de l'amplitude du signal de mesure d'accélération Smx, Smy, Smz à des seuils est aisée à mettre en œuvre sur le contrôleur 40 et demande peu de puissance de calcul.

La détermination d'une usure lorsque la durée de commutation Dc dépasse un seuil correspondant permet de détecter simplement et efficacement certaines usures. En particulier, une usure des pastilles de contact 60, menant à une diminution excessive de l'épaisseur e voire à un contact direct entre l'élément de connexion 45 et la plage de connexion 15, 20 correspondante débouche sur une augmentation de la distance de course de l'organe de commutation, et donc sur une augmentation de la durée de commutation Dc. Une telle usure est donc efficacement déterminée par une comparaison de la durée de commutation Dc à un seuil.

Lorsque l'accéléromètre 35 est solidaire du boîtier 30, la connexion de l'accéléromètre 35 au contrôleur 40 est facilitée. Par exemple, l'accéléromètre 35 est susceptible d'être intégré sur une même carte électronique que le contrôleur 40.

Lorsque l'accéléromètre 35 est solidaire de l'organe de commutation 25, l'amplitude de l'accélération mesurée est plus élevée, et le procédé de détection de l'usure est donc plus précis.

Grâce aux filtrages appliqués, les signaux parasites à haute ou basse fréquence sont supprimés, ce qui évite la détection de faux positifs.

Le premier exemple de dispositif de commutation 10 et le procédé de détection associé décrits ci-dessus ont été décrits dans le cas d'un type d'organe de connexion 25 particulier dont l'élément de connexion est mobile en translation par rapport à la direction Z qui est l'une des directions selon lesquelles l'accéléromètre 35 est configuré pour mesurer une composante d'accélération c. Il est à noter que d'autres types d'organes de connexion 25 sont susceptibles d'être utilisés, et que l'accéléromètre 35 est susceptible d'être orienté différemment par rapport au mouvement de l'organe de connexion 25. Les signatures utilisées pour la détection des instants de début et de fin de course T1, T2 sont donc susceptibles de varier d'un modèle de dispositif de commutation à un autre.

Il est à noter également que les signatures identifiées sont également susceptibles de varier en fonction de la position et de l'orientation de l'accéléromètre 35 dans le dispositif de commutation 10.

Par exemple, dans certains modèles de dispositifs de commutation, les signatures des instants de début et de fin de course T1, T2 sont susceptibles d'être détectées dans un même signal de mesure d'accélération Sm correspondant à une composante d'accélération selon une direction X, Y ou Z.

Il est également à noter que différents types d'usure sont susceptibles d'être déterminés. Par exemple, une usure de pastilles de contact 60 est déterminée à partir des signaux de mesure d'accélération Sm correspondant à deux directions X et Y, et une usure d'une pièce autre que les pastilles de contact 60 est déterminée à partir de l'identification d'une signature détectée dans le signal de mesure d'accélération Sm correspondant à la direction Z.

Un coincement ou un frottement excessif de la partie mobile 50 sont d'autres exemples d'usures susceptibles d'être détectées.

Un deuxième exemple de dispositif de commutation 10 va maintenant être décrit. Les éléments identiques au premier exemple des figures 1 à 4 ne sont pas décrits à nouveau. Seules les différences sont mises en évidence.

Chaque signal de mesure d'accélération Sm comporte un ensemble de composantes fréquentielles. Chaque composante fréquentielle présente une intensité.

Le contrôleur 40 est configuré pour détecter, à partir d'au moins un signal de mesure d'accélération, l'instant de fin d'appui T3, et pour détecter une usure à partir de l'instant de fin d'appui T3 détecté.

Le contrôleur 40 est, en outre, configuré pour estimer l'intensité d'au moins deux composantes fréquentielles. Par exemple, le contrôleur 40 est configuré pour estimer, à chaque instant, l'intensité de chaque composante fréquentielle d'une gamme de fréquences prédéterminées au cours d'une commutation.

Différentes méthodes sont susceptibles d'être utilisées par le contrôleur 40 pour estimer l'intensité des composantes fréquentielles. Selon un mode de réalisation, le contrôleur 40 est configuré pour effectuer une décomposition fréquentielle du signal de mesure d'accélération Sm, par exemple par un procédé du type « transformée de Fourier à court terme ».

Le contrôleur 40 est configuré pour détecter au moins un instant de début ou de fin de course T1, T2, ou de fin d'appui T3 par détection comparaison du signal de mesure Sm à une signature correspondante, la signature étant une fonction des intensités d'au moins deux composantes fréquentielles.

Par exemple, le contrôleur 40 est configuré pour détecter, dans la décomposition fréquentielle du signal de mesure d'accélération, une gamme de fréquence sur laquelle l'intensité de chaque composante fréquentielle est supérieure ou égale à un quatrième seuil. Selon un mode de réalisation, l'instant de fin d'appui T3 est détecté lorsque, sur une gamme continue de fréquence prédéterminée, chaque composante fréquentielle présente une intensité supérieure ou égale au quatrième seuil.

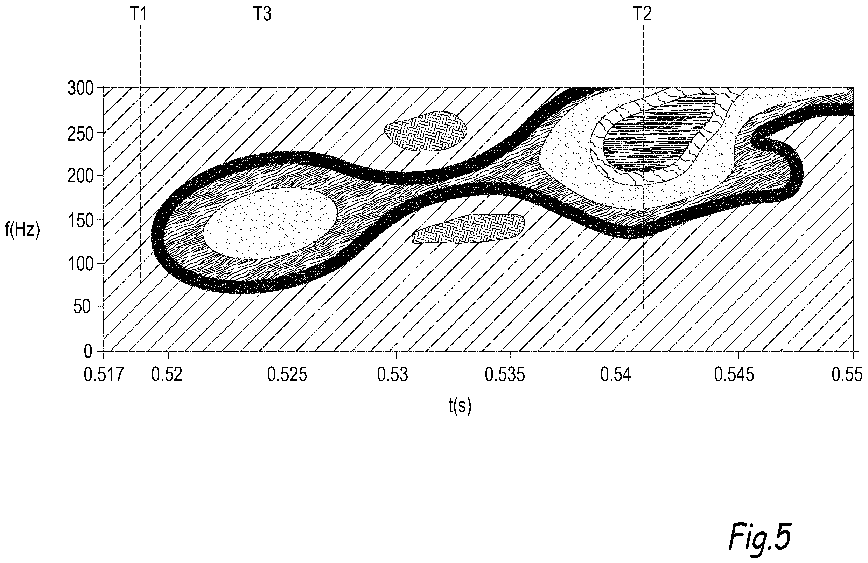

Ainsi, sur la figure 5 la variation de l'amplitude des différentes composantes fréquentielles du signal de mesure Sm selon la direction Y au cours d'une commutation a été représentée, en fonction de la fréquence f de chaque composante fréquentielle et du temps t, en millisecondes. Les instants de début et de fin de course T1, T2, et de fin d'appui T3 ont été mis en évidence.

Sur la figure 5, on voit que l'instant de fin d'appui T3 est efficacement détecté lorsque l'intensité de chaque composante fréquentielle comprise entre 100 Hz et 200Hz est supérieure ou égale au quatrième seuil.

En variante, l'instant de fin d'appui T3 correspond au moment où l'intensité minimale de toutes les composantes de la gamme prédéterminée de fréquences atteint un maximum.

Selon une autre variante, deux instants T1, T2 ou T3 sont identifiés par le calculateur 40 par comparaison des intensités de deux composantes fréquentielles distinctes à deux seuils différents. Selon l'exemple de la figure 5, l'instant de fin d'appui T3 est détecté lorsque l'intensité de la composante fréquentielle à 150 Hz présente un maximum, et l'instant de fin de course T2 lorsque la composante fréquentielle à 250 Hz présente un maximum d'intensité.

L'étude des composantes fréquentielles du signal de mesure Sm permet de détecter efficacement l'instant de fin d'appui T3. La durée temporelle entre l'instant de début de course T et l'instant de fin d'appui T3 est également corrélée à l'usure des pastilles 60.

En outre, la signature de l'instant de fin d'appui T3 est susceptible de varier en fonction de l'usure des pastilles de contact 60. Par exemple, une usure prononcée des pastilles de contact 60 est susceptible de conduire à une diminution de l'intensité maximale des composantes fréquentielles les plus intenses et à une augmentation de l'intensité maximale des autres composantes fréquentielles. En d'autres termes, plus les pastilles de contact 60 sont usées, plus la tâche visible à l'instant T3 sur la figure 5 sera large et moins elle sera intense.

Les premier et deuxième exemples ci-dessus ont été décrits dans le cas où le contrôleur 40 comporte un processeur et une mémoire dans laquelle des instructions logicielles sont mémorisées. Il est à noter que les fonctionnalités du contrôleur 40 sont également susceptibles d'être réalisées sous forme de circuits logiques programmables, ou encore d'un ou plusieurs circuits intégrés dédiés. Par exemple, le contrôleur 40 comporte un module de détection de l'instant de début de course T1, un module de détection de l'instant de fin de course T2, un module de détection de l'instant de fin d'appui T3, un module d'estimation de la durée de commutation Dc, un module de comparaison de la durée de comparaison Dc à un seuil et un module de détermination de l'usure.

Il est également à noter que, dans certains modes de réalisation, le contrôleur 40 est susceptible d'être situé hors du boîtier 30, par exemple dans un cas où le contrôleur 40 reçoit par communication radiofréquence, par exemple de type RFID, ou filaire les signaux de mesure d'accélération Sm générés par l'accéléromètre 35. Dans ce cas, un contrôleur 40 est susceptible d'être commun à plusieurs dispositifs de commutation 10.

Les revendications suivantes définissent l'objet de l'invention.

## Revendications

1. Dispositif de commutation électrique (10) comprenant au moins une plage de connexion d'entrée (15), au moins une plage de connexion de sortie (20), et au moins un organe de connexion (25) propre à commuter entre une position fermée autorisant le passage du courant électrique entre les plages de connexion d'entrée et de sortie (15, 20) et une position ouverte empêchant le passage du courant électrique entre les plages de connexion d'entrée et de sortie (15, 20),
le dispositif de commutation électrique (10) comportant un accéléromètre (35) propre à mesurer au moins une composante d'une accélération du dispositif de commutation électrique (10) lors d'une commutation de l'organe de connexion (25) entre la position fermée et la position ouverte et un contrôleur (40) configuré pour estimer, à partir d'au moins un signal de mesure d'accélération délivré par l'accéléromètre (35), une durée de commutation de l'organe de connexion (25) entre la position fermée et la position ouverte, et pour déterminer une usure du dispositif de commutation électrique (10) à partir, au moins, de la durée de commutation estimée,
dans lequel l'organe de connexion (25) comprend un élément de connexion (45) et un actionneur (47), l'élément de connexion (45) étant mobile par rapport aux plages de connexion (15, 20) entre une première position et une deuxième position et étant configuré pour connecter électriquement les deux plages de connexion (15, 20) lorsque l'élément de connexion (45) est dans la première position et pour déconnecter électriquement les deux plages de connexion (15, 20) lorsque l'élément de connexion (45) est dans la deuxième position,
l'actionneur comprenant au moins une partie (50) mobile par rapport aux plages de connexion (15, 20) entre une troisième position et une quatrième position, la partie mobile (50) étant dans la troisième position et l'élément de connexion (45) étant dans la première position lorsque l'organe de connexion (25) est dans la position fermée, la partie mobile (50) étant dans la quatrième position et l'élément de connexion (45) étant dans la deuxième position lorsque l'organe de connexion (25) est dans la position ouverte,
la partie mobile (50) étant configurée pour être distante de l'élément de connexion (45) lorsque la partie mobile (50) est dans la troisième position et étant configurée pour, lors de son déplacement depuis la troisième position jusqu'à la quatrième position, venir en appui contre l'élément de connexion (45) pour déplacer l'élément de connexion (45) depuis la première position jusqu'à la deuxième position,
le dispositif de commutation électrique étant **caractérisé en ce que** le contrôleur (40) est, en outre, configuré pour détecter, à partir, au moins, du signal de mesure d'accélération, un instant de fin d'appui (T3) d'un appui de la partie mobile (50) contre l'élément de connexion (45), l'usure étant déterminée, en outre, à partir de l'instant de fin d'appui (T3) détecté.

2. Dispositif de commutation électrique (10) selon la revendication 1, dans lequel le contrôleur (40) est configuré pour déterminer une usure du dispositif de commutation (10) lorsque la durée de commutation est supérieure ou égale à un seuil prédéterminé.

3. Dispositif de commutation électrique (10) selon la revendication 1 ou 2, dans lequel le contrôleur (40) est configuré pour vérifier si l'usure déterminée est supérieure à un seuil d'usure prédéterminé et, dans l'affirmative, pour générer un signal de détection à destination d'un usager du dispositif de commutation électrique (10).

4. Dispositif de commutation électrique (10) selon l'une quelconque des revendications 1 à 3, comportant un boîtier (30) propre à isoler électriquement l'organe de connexion (25) de l'extérieur du boîtier (30), l'organe de connexion (25) étant mobile par rapport au boîtier (30) entre sa position ouverte et sa position fermée, et dans lequel l'accéléromètre (35) est solidaire du boîtier.

5. Dispositif de commutation électrique (10) selon l'une quelconque des revendications 1 à 3, comportant un boîtier (30) propre à isoler électriquement l'organe de connexion (25) de l'extérieur du boîtier (30), l'organe de connexion (25) étant mobile par rapport au boîtier (30) entre sa position ouverte et sa position fermée, et dans lequel l'accéléromètre (35) est solidaire de l'organe de connexion (25) et par conséquent mobile par rapport au boîtier (30).

6. Dispositif de commutation électrique (10) selon l'une quelconque des revendications 1 à 5, dans lequel le contrôleur (40) est configuré pour détecter, lorsque l'organe de connexion (25) commute entre la position fermée et la position ouverte, un instant de début et un instant de fin de course (T1, T2) d'une course de l'organe de connexion (25), et pour estimer la durée de commutation à partir des instants de début et de fin de course (T1, T2) détectés.

7. Dispositif de commutation électrique (10) selon la revendication 6, dans lequel le contrôleur (40) est configuré pour comparer une amplitude du signal de mesure d'accélération à un premier seuil et pour détecter l'instant de début de course (T1) lorsque l'amplitude dépasse le premier seuil.

8. Dispositif de commutation électrique (10) selon l'une quelconque des revendications 6 et 7, dans lequel le contrôleur (40) est configuré pour comparer une amplitude d'un signal de mesure de l'accélération à un deuxième seuil et pour détecter l'instant de fin de course (T2) lorsque, après qu'un instant de début de course (T1) a été détecté, l'amplitude devient supérieure ou égale au deuxième seuil.

9. Dispositif de commutation électrique (10) selon l'une quelconque des revendications 1 à 8, dans lequel le signal de mesure d'accélération comprend un ensemble de composantes fréquentielles présentant chacune une intensité, le contrôleur (40) étant configuré pour détecter l'instant de fin d'appui (T3) lorsque, sur une gamme continue de fréquences présentant une largeur fréquentielle prédéterminée, l'intensité de chaque composante fréquentielle est supérieure ou égale à un troisième seuil prédéterminé.

10. Dispositif de commutation électrique (10) selon l'une quelconque des revendications 1 à 9, dans lequel le dispositif de commutation (10) est un contacteur.

11. Procédé de détection d'usure pour un dispositif de commutation électrique (10) comprenant un accéléromètre (35), au moins une plage de connexion d'entrée (15), une plage de connexion de sortie (20) et un organe de connexion (25), propre à commuter entre une position fermée autorisant le passage du courant électrique entre les plages de connexion d'entrée et de sortie (15, 20) et une position fermée empêchant le passage du courant électrique, l'organe de connexion (25) comprenant un élément de connexion (45) et un actionneur (47), l'élément de connexion (45) étant mobile par rapport aux plages de connexion (15, 20) entre une première position et une deuxième position et étant configuré pour connecter électriquement les deux plages de connexion (15, 20) lorsque l'élément de connexion (45) est dans la première position et pour déconnecter électriquement les deux plages de connexion (15, 20) lorsque l'élément de connexion (45) est dans la deuxième position,
l'actionneur comprenant au moins une partie (50) mobile par rapport aux plages de connexion (15, 20) entre une troisième position et une quatrième position, la partie mobile (50) étant dans la troisième position et l'élément de connexion (45) étant dans la première position lorsque l'organe de connexion (25) est dans la position fermée, la partie mobile (50) étant dans la quatrième position et l'élément de connexion (45) étant dans la deuxième position lorsque l'organe de connexion (25) est dans la position ouverte,
la partie mobile (50) étant configurée pour être distante de l'élément de connexion (45) lorsque la partie mobile (50) est dans la troisième position et étant configurée pour, lors de son déplacement depuis la troisième position jusqu'à la quatrième position, venir en appui contre l'élément de connexion (45) pour déplacer l'élément de connexion (45) depuis la première position jusqu'à la deuxième position,
le procédé comportant des étapes de :
- commutation (110) de l'organe de connexion (25) entre la position fermée et la position ouverte,
- génération (120), par l'accéléromètre (35), d'un signal de mesure d'accélération correspondant au moins à une composante d'une accélération du dispositif de commutation (10) lors de la commutation,
- estimation (130), à partir du signal de mesure d'accélération, d'une durée de commutation de l'organe de connexion (25) entre la position fermée et la position ouverte, et
- détermination (140) d'une usure du dispositif de commutation (10) à partir, au moins, de la durée de commutation estimée,
le procédé étant **caractérisé en ce que** la détermination (140) d'une usure comporte la détection par le contrôleur d'un instant de fin d'appui (T3) d'un appui de la partie mobile (50) contre l'élément de connexion (45) à partir, au moins, du signal de mesure d'accélération, l'usure étant déterminée, en outre, à partir de l'instant de fin d'appui (T3) détecté.

12. Procédé de détection d'usure selon la revendication 11, comprenant, en outre, une étape de calibration consistant à générer un signal de mesure d'accélération pendant au moins une commutation et à identifier, dans le signal de mesure d'accélération fourni par l'accéléromètre (35), au moins une signature d'un instant de début ou de fin de course (T1, T2) de l'organe de connexion (25), l'étape d'estimation (130) comprenant la détection d'un instant de début ou de fin de course de l'organe de connexion (25) par comparaison du signal de mesure d'accélération généré pendant l'étape de génération (120) à la signature identifiée.

## Patentansprüche

1. - Elektrische Schaltvorrichtung (10), umfassend mindestens einen Eingangsverbindungsbereich (15), mindestens einen Ausgangsverbindungsbereich (20) und mindestens ein Verbindungsorgan (25), das geeignet ist, um zwischen einer geschlossenen Position, die den Durchgang des elektrischen Stroms zwischen dem Eingangs- und dem Ausgangsverbindungsbereich (15, 20) zulässt, und einer offenen Position, die den Durchgang des elektrischen Stroms zwischen dem Eingangs- und dem Ausgangsverbindungsbereich (15, 20) verhindert, umzuschalten,
die elektrische Schaltvorrichtung (10) umfassend einen Beschleunigungsmesser (35), der geeignet ist, um mindestens eine Komponente einer Beschleunigung der elektrischen Schaltvorrichtung (10) bei einem Umschalten des Verbindungsorgans (25) zwischen der geschlossenen Position und der offenen Position zu messen, und eine Steuerung (40), die konfiguriert ist, um anhand mindestens einem Beschleunigungsmesssignal, das von dem Beschleunigungsmesser (35) ausgegeben wird, eine Umschaltdauer des Verbindungsorgans (25) zwischen der geschlossenen Position und der offenen Position zu schätzen, und um einen Verschleiß der elektrischen Schaltvorrichtung (10) anhand mindestens der geschätzten Umschaltdauer zu bestimmen,
wobei das Verbindungsorgan (25) ein Verbindungselement (45) und einen Stellantrieb (47) umfasst, wobei das Verbindungselement (45) in Bezug auf die Verbindungsbereiche (15, 20) zwischen einer ersten Position und einer zweiten Position beweglich und konfiguriert ist, um die zwei Verbindungsbereiche (15, 20) elektrisch zu verbinden, wenn das Verbindungselement (45) in der ersten Position ist, und um die zwei Verbindungsbereiche (15, 20) elektrisch zu trennen, wenn das Verbindungselement (45) in der zweiten Position ist,
wobei der Stellantrieb mindestens einen Abschnitt (50) umfasst, der in Bezug auf die Verbindungflächen (15, 20) zwischen einer dritten Position und einer vierten Position beweglich ist, wobei der bewegliche Abschnitt (50) in der dritten Position und das Verbindungselement (45) in der ersten Position sind, wenn das Verbindungsorgan (25) in der geschlossenen Position ist, wobei der bewegliche Abschnitt (50) in der vierten Position und das Verbindungselement (45) in der zweiten Position sind, wenn das Verbindungsorgan (25) in der offenen Position ist,
wobei der bewegliche Abschnitt (50) konfiguriert ist, um von dem Verbindungselement (45) beabstandet zu sein, wenn der bewegliche Abschnitt (50) in der dritten Position ist, und konfiguriert ist, um bei seiner Bewegung aus der dritten Position in die vierte Position an dem Verbindungselement (45) anzuliegen, um das Verbindungselement (45) aus der ersten Position in die zweite Position zu bewegen,
wobei die elektrische Schaltvorrichtung **dadurch gekennzeichnet ist, dass** die Steuerung (40) ferner konfiguriert ist, um mindestens anhand des Beschleunigungsmesssignals einen Anlageendzeitpunkt (T3) einer Anlage eines des beweglichen Abschnitts (50) an dem Verbindungselement (45) zu erfassen, wobei der Verschleiß ferner anhand des erfassten Anlageendzeitpunkts (T3) bestimmt wird.

2. - Elektrische Schaltvorrichtung (10) nach Anspruch 1, wobei die Steuerung (40) konfiguriert ist, um einen Verschleiß der Schaltvorrichtung (10) zu bestimmen, wenn die Umschaltdauer größer als oder gleich wie ein vorbestimmte Schwellenwert ist.

3. - Elektrische Schaltvorrichtung (10) nach Anspruch 1 oder 2, wobei die Steuerung (40) konfiguriert ist, um zu prüfen, ob der bestimmte Verschleiß über einem vorbestimmten Verschleißschwellenwert ist, und, wenn ja, ein Erfassungssignal gerichtet an einen Benutzer der elektrischen Schaltvorrichtung (10) zu erzeugen.

4. - Elektrische Schaltvorrichtung (10) nach einem der Ansprüche 1 bis 3, umfassend ein Gehäuse (30), das geeignet ist, um das Verbindungsorgan (25) elektrisch von der Außenseite des Gehäuses (30) zu isolieren, wobei das Verbindungsorgan (25) in Bezug auf das Gehäuse (30) zwischen seiner offenen Position und seiner geschlossenen Stellung beweglich ist, und wobei der Beschleunigungsmesser (35) fest mit dem Gehäuse verbunden ist.

5. - Elektrische Schaltvorrichtung (10) nach einem der Ansprüche 1 bis 3, umfassend ein Gehäuse (30), das geeignet ist, um das Verbindungsorgan (25) elektrisch von der Außenseite des Gehäuses (30) zu isolieren, wobei das Verbindungsorgan (25) in Bezug auf das Gehäuse (30) zwischen seiner offenen Position und seiner geschlossenen Stellung beweglich ist, und wobei der Beschleunigungsmesser (35) fest mit dem Verbindungsorgan (25) verbunden und folglich in Bezug auf das Gehäuse (30) beweglich ist.

6. - Elektrische Schaltvorrichtung (10) nach einem der Ansprüche 1 bis 5, wobei die Steuerung (40) konfiguriert ist, um, wenn das Verbindungsorgan (25) zwischen der geschlossenen Position und der offenen Position umschaltet, einen Hubanfangszeitpunkt und einen Hubendzeitpunkt (T1, T2) eines Hubs des Verbindungsorgans (25) zu erfassen, und um die Umschaltdauer anhand der erfassten Hubanfangs- und Hubendzeitpunkte (T1, T2) zu schätzen.

7. - Elektrische Schaltvorrichtung (10) nach Anspruch 6, wobei die Steuerung (40) konfiguriert ist, um eine Amplitude des Beschleunigungsmesssignals mit einem ersten Schwellenwert zu vergleichen und den Hubanfangszeitpunkt (T1) zu erfassen, wenn die Amplitude den ersten Schwellenwert übersteigt.

8. - Elektrische Schaltvorrichtung (10) nach einem der Ansprüche 6 oder 7, wobei die Steuerung (40) konfiguriert ist, um eine Amplitude eines Beschleunigungsmesssignals mit einem zweiten Schwellenwert zu vergleichen und den Endzeitpunkt (T2) zu erfassen, wenn, nachdem ein Hubanfangszeitpunkt (T1) erfasst wurde, die Amplitude größer als oder gleich wie der zweite Schwellenwert wird.

9. - Elektrische Schaltvorrichtung (10) nach einem der Ansprüche 1 bis 8, wobei das Beschleunigungsmesssignal einen Satz von Frequenzkomponenten umfasst, die jeweils eine Intensität aufweisen, wobei die Steuerung (40) konfiguriert ist, um den Anlageendzeitpunkt (T3) zu erfassen, wenn über einen kontinuierlichen Bereich von Frequenzen mit einer vorbestimmten Frequenzbreite die Intensität jeder Frequenzkomponente größer als oder gleich wie ein dritter vorbestimmter Schwellenwert ist.

10. - Elektrische Schaltvorrichtung (10) nach einem der Ansprüche 1 bis 9, wobei die Schaltvorrichtung (10) ein Schaltschütz ist.

11. - Verfahren zur Verschleißerkennung für eine elektrische Schaltvorrichtung (10), umfassend einen Beschleunigungsmesser (35), mindestens einen Eingangsverbindungsbereich (15), einen Ausgangsverbindungsbereich (20) und ein Verbindungsorgan (25), das geeignet ist, um zwischen einer geschlossenen Position, die den Durchgang des elektrischen Stroms zwischen dem Eingangs- und dem Ausgangsverbindungsbereich (15, 20) zulässt, und einer offenen Position, die den Durchgang des elektrischen Stroms verhindert, umzuschalten, das Verbindungsorgan (25) umfassend ein Verbindungselement (45) und einen Stellantrieb (47), wobei das Verbindungselement (45) in Bezug auf die Verbindungsbereiche (15, 20) zwischen einer ersten Position und einer zweiten Position beweglich und konfiguriert ist, um die zwei Verbindungsbereiche (15, 20) elektrisch zu verbinden, wenn das Verbindungselement (45) in der ersten Position ist, und um die zwei Verbindungsbereiche (15, 20) elektrisch zu trennen, wenn das Verbindungselement (45) in der zweiten Position ist,
wobei der Stellantrieb mindestens einen Abschnitt (50) umfasst, der in Bezug auf die Verbindungflächen (15, 20) zwischen einer dritten Position und einer vierten Position beweglich ist, wobei der bewegliche Abschnitt (50) in der dritten Position und das Verbindungselement (45) in der ersten Position sind, wenn das Verbindungsorgan (25) in der geschlossenen Position ist, wobei der bewegliche Abschnitt (50) in der vierten Position und das Verbindungselement (45) in der zweiten Position sind, wenn das Verbindungsorgan (25) in der offenen Position ist,
wobei der bewegliche Abschnitt (50) konfiguriert ist, um von dem Verbindungselement (45) beabstandet zu sein, wenn der bewegliche Abschnitt (50) in der dritten Position ist, und konfiguriert ist, um bei seiner Bewegung aus der dritten Position in die vierte Position an dem Verbindungselement (45) anzuliegen, um das Verbindungselement (45) aus der ersten Position in die zweite Position zu bewegen,
das Verfahren umfassend die folgenden Schritte:
- Umschalten (110) des Verbindungselements (25) zwischen der geschlossenen und der offenen Position,
- Erzeugen (120), durch den Beschleunigungsmesser (35), eines Beschleunigungsmesssignals, das mindestens einer Komponente einer Beschleunigung der Schaltvorrichtung (10) während des Umschaltens entspricht,
- Schätzen (130), anhand des Beschleunigungsmesssignals, einer Umschaltdauer des Umschaltens des Verbindungsorgans (25) zwischen der geschlossenen Position und der offenen Position, und
- Bestimmen (140) eines Verschleißes der Schaltvorrichtung (10) anhand mindestens der geschätzten Umschaltdauer,
wobei das Verfahren **dadurch gekennzeichnet ist, dass** das Bestimmen (140) eines Verschleißes das Erfassen eines Anlageendzeitpunkts (T3) des beweglichen Abschnitts (50) an dem Verbindungselement (45) durch die Steuerung anhand mindestens des Beschleunigungsmesssignals umfasst, wobei der Verschleiß ferner anhand des erfassten Anlageendzeitpunkts (T3) bestimmt wird.

12. Verfahren zur Verschleißerkennung nach Anspruch 11, ferner umfassend einen Kalibrierungsschritt, der darin besteht, während mindestens einer Umschaltung ein Beschleunigungsmesssignal zu erzeugen und in dem vom Beschleunigungsmesser (35) bereitgestellten Beschleunigungsmesssignal mindestens eine Signatur eines Hubanfangs- oder Hubendzeitpunkts (T1, T2) des Verbindungsorgans (25) zu schätzen, wobei der Schätzungsschritt (130) das Erfassen eines Hubanfangs- oder Hubendzeitpunkts des Verbindungsorgans (25) durch Vergleichen des während des Erzeugungsschritts (120) erzeugten Beschleunigungsmesssignals mit der identifizierten Signatur umfasst.

## Claims

1. An electrical switching device (10) comprising at least one input connection pad (15), at least one output connection pad (20), and at least one connection member (25) adapted to switch between a closed position allowing the passage of electrical current between the input and output connection pads (15, 20) and an open position preventing the passage of electrical current between the input and output connection pads (15, 20),
the electrical switching device (10) comprising an accelerometer (35) adapted to measure at least one component of an acceleration of the electrical switching device (10) when switching the connection member (25) between the closed position and the open position and a controller (40) configured to estimate, based on at least one acceleration measurement signal delivered by the accelerometer (35), a switching time taken by the connection member (25) to switch between the closed position and the open position, and to determine the electrical switching device's (10) wear based on at least the estimated switching time,
wherein the connection member (25) comprises a connection element (45) and an actuator (47), the connection element (45) being movable relative to the connection pads (15, 20) between a first position and a second position and being configured to electrically connect the two connection pads (15, 20) when the connection element (45) is in the first position and to electrically disconnect the two connection pads (15, 20) when the connection element (45) is in the second position,
the actuator comprising at least one part (50) movable relative to the connection pads (15, 20) between a third position and a fourth position, the movable part (50) being in the third position and the connection element (45) being in the first position when the connection member (25) is in the closed position, the movable part (50) being in the fourth position and the connection element (45) being in the second position when the connection member (25) is in the open position,
the movable part (50) being configured to be away from the connecting member (45) when the movable part (50) is in the third position, and being configured such that upon movement from the third position to the fourth position, it abuts against the connecting member (45) in order to move the connecting member (45) from the first position to the second position,
the electrical switching device being **characterized in that** the controller (40) is further configured to detect, from at least the acceleration measurement signal, an end time (T3) of a pressing of the movable part (50) against the connecting element (45), the wear being further determined from the detected pressing end time (T3).

2. The electrical switching device (10) of claim 1, wherein the controller (40) is configured to determine wear and tear of the switching device (10) when the switching time is greater than or equal to a predetermined threshold.

3. The electrical switching device (10) according to claim 1 or 2, wherein the controller (40) is configured to check whether the determined wear and tear is above a predetermined wear and tear threshold and, if so, to generate a detection signal to a user of the electrical switching device (10).

4. The electrical switching device (10) according to any one of claims 1 to 3, comprising a housing (30) adapted to electrically isolate the connection member (25) from the exterior of the housing (30), the connection member (25) being movable relative to the housing (30) between its open position and its closed position, and wherein the connection member (35) is integral with the housing.

5. The electrical switching device (10) according to any one of claims 1 to 3, comprising a housing (30) adapted to electrically isolate the connection member (25) from the exterior of the housing (30), the connection member (25) being movable relative to the housing (30) between its open position and its closed position, and wherein the accelerometer (35) is rigidly connected to the connection member (25) and as such movable with respect to the housing (30).

6. The electrical switching device (10) according to any one of claims 1 to 5, wherein the controller (40) is configured to detect, when the connecting member (25) switches between the closed position and the open position, a start time and an end time (T1, T2) of a stroke of the connecting member (25), and to estimate the switching time from the detected start and end times (T1, T2).

7. The electrical switching device (10) of claim 6, wherein the controller (40) is configured to compare an amplitude of the acceleration measurement signal to a first threshold and to detect the stroke start time (T1) when the amplitude exceeds the first threshold.

8. The electrical switching device (10) according to any one of claims 6 and 7, wherein the controller (40) is configured to compare an amplitude of an acceleration measurement signal with a second threshold and to detect the stroke end time (T2) when, after a stroke start time (T1) has been detected, the amplitude becomes greater than or equal to the second threshold.

9. The electrical switching device (10) according to any one of claims 1 to 8, wherein the acceleration measurement signal comprises a set of frequency components each having an intensity, the controller (40) being configured to detect the pressing end time (T3) when, over a continuous range of frequencies having a predetermined frequency width, the intensity of each frequency component is greater than or equal to a third predetermined threshold.

10. The electrical switching device (10) according to any one of claims 1 to 9, wherein the switching device (10) is a contactor.

11. A method of detecting wear and tear for an electrical switching device (10) comprising an accelerometer (35), at least one input pad (15), an output pad (20) and a connection member (25), adapted to switch between a closed position allowing the passage of electrical current between the input and output pads (15, 20) and a closed position preventing the passage of electrical current, the connection member (25) comprising a connection element (45) and an actuator (47), the connection element (45) being movable relative to the connection pads (15, 20) between a first position and a second position and being configured to electrically connect the two connection pads (15, 20) when the connection element (45) is in the first position and to electrically disconnect the two connection pads (15, 20) when the connection element (45) is in the second position,
the actuator comprising at least one part (50) movable relative to the connection pads (15, 20) between a third position and a fourth position, the movable part (50) being in the third position and the connection element (45) being in the first position when the connection member (25) is in the closed position, the movable part (50) being in the fourth position and the connection element (45) being in the second position when the connection member (25) is in the open position,
the movable part (50) being configured to be away from the connecting member (45) when the movable part (50) is in the third position, and being configured such that upon movement from the third position to the fourth position, it abuts against the connecting member (45) in order to move the connecting member (45) from the first position to the second position,
the method comprising the steps of:
- switching (110) the switching member (25) between the closed and open positions,
- generating (120), by the accelerometer (35), an acceleration measurement signal corresponding at least to a component of an acceleration of the switching device (10) during switching,
- estimating (130), from the acceleration measurement signal, a switching time of the connecting member (25) between the closed position and the open position, and
- determining (140) a wear and tear of the switching device (10) from at least the estimated switching time,
the method being **characterised in that** determining (140) wear and tear comprises the detection by the controller of a pressing end time (T3) when support by the movable part (50) against the connection element (45) ends, from at least the acceleration measurement signal, the wear and tear being determined, in addition, from the detected pressing end time (T3).

12. The wear detection method according to claim 11, further comprising a calibration step consisting of generating an acceleration measurement signal during at least one switching and identifying, in the acceleration measurement signal provided by the accelerometer (35), at least one signature of a stroke start or end time (T1, T2) of the connection member (25), the estimating step (130) comprising the detection of a stroke start or end time of the connection member (25) comparing the acceleration measurement signal generated during the generation step (120) with the identified signature.
